Europäisches Patentamt

European Patent Office

Office européen des brevets

(11) Publication number: **0 055 594**
**B1**

# EUROPEAN PATENT SPECIFICATION

(45) Date of publication of patent specification: **13.07.88**

(51) Int. Cl.⁴: **G 11 C 29/00**

(21) Application number: **81306062.1**

(22) Date of filing: **22.12.81**

(54) **Electrically programmable non-volatile semiconductor memory device.**

(30) Priority: **23.12.80 JP 182289/80**
**23.12.80 JP 182294/80**

(43) Date of publication of application:
**07.07.82 Bulletin 82/27**

(45) Publication of the grant of the patent:
**13.07.88 Bulletin 88/28**

(84) Designated Contracting States:
**DE FR GB NL**

(56) References cited:
**GB-A-2 049 202**
**US-A-4 103 189**

(73) Proprietor: **FUJITSU LIMITED**
**1015, Kamikodanaka Nakahara-ku**
**Kawasaki-shi Kanagawa 211 (JP)**

(72) Inventor: **Yoshida, Masanobu**
**3-3-3, Suehiro**
**Kawaguchi-shi Saitama 332 (JP)**

(74) Representative: **Abbott, Leonard Charles**
**GILL JENNINGS & EVERY 53-64 Chancery Lane**
**London WC2A 1HN (GB)**

Courier Press, Leamington Spa, England.

## Description

The present invention relates to an electrically programmable non-volatile semiconductor memory device. More specifically, the present invention relates to a circuit structure for shortening the stress application time and the time for writing "0" in all the cells at the time of testing in an electrically programmable non-volatile semiconductor memory device.

In an electrically programmable non-volatile semiconductor memory device, such as an EPROM (Electrically programmable read only memory), a cell for one bit is formed by a source, a drain, a floating gate and a control gate. Ordinarily, the source is grounded, and the drain is connected to a bit line. Control gates of all the cells aligned in the row direction are integrated to become a word line, and this word line is selected when the control gates are maintained at a high potential. When a certain bit line is selected and the drain of the cell located at the crosspoint is maintained at a high potential, an information "0" is written and if the high potential is changed to a low potential, the information "0" is also written. Incidentally, the information "0" corresponds to the state where charges are present on the floating gate, and the information "1" corresponds to the state where no charges are present on the floating gate. Further, the erase operation is carried out, so that the information "1" is written into all the cells (no charges are present on the floating gate), by applying an energy ray, such as an ultra-violet ray. The write operation is carried out by placing the bit line at a high level, only when the information "1" is changed to the information "0". If the bit line is maintained at a low potential, no current flows in the channel; therefore, no electric charges are injected. The relation among the information "0", "1", the potential (H · L) of the word line and the existence or non-existence of the charges is shown in the following table.

| Information | Word line | Bit line | Charge in the floating gate |
|---|---|---|---|
| "1" | H potential | L potential | non-existent |
| "0" | H potential | H potential | exists |

For example, if the cell array is formed by 64 K-bits (one block is formed by 8 K-bits), each cell is selected by using 256 word lines and 32 column decoder output lines. As mentioned hereafter, the column decoder output lines are used for selecting the bit lines. Here, each time one bit is selected in one block, the decoder outputs of the rows, as well as the columns, should be changed. This is carried out for the purpose of preventing multi-selection and this operation should be indispensable in the usual operation of this device.

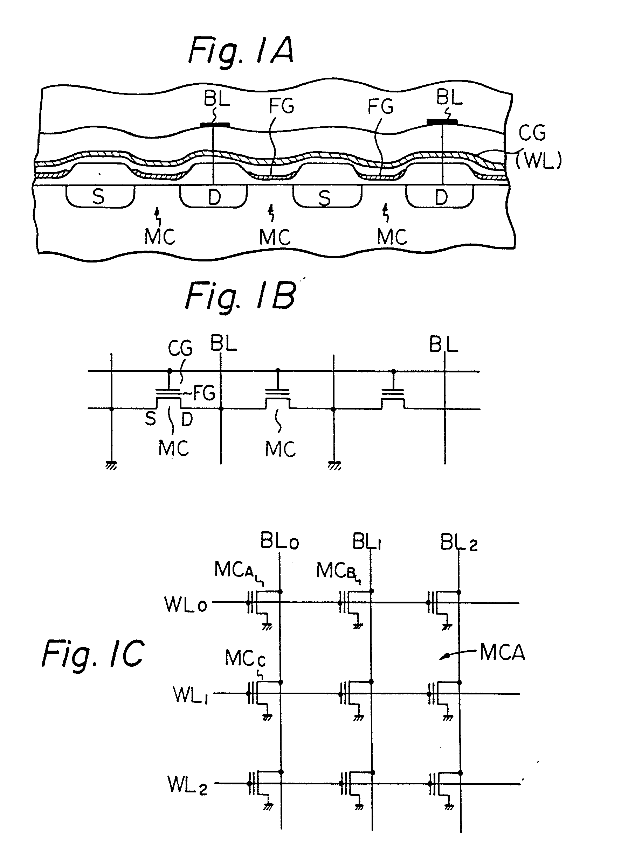

In such an EPROM, at the time of writing in half-selected cells, undesirable phenomena, as described below, sometimes take place depending on the quality of the polycrystalline silicon constituting the floating gate FG or the quality of a peripheral insulating film. These undesirable phenomena will now be described with reference to Fig. 1C, following a description of a conventional memory device.

In an electrically programmable non-volatile semiconductor memory device, for example, an EPROM, as shown in Figure 1A, a cell MC of one bit is constructed by a source S, a drain D, a floating gate FG and a control gate CG. Ordinarily, the source S is grounded and the drain D is connected to a bit line BL. Control gates CG of all the cells aligned in the row direction are integrated as a word line WL, and this word line is selected when the control gate CG is maintained at a high potential. When a certain bit line BL is then selected and the drain of the cell MC located at the crossing point is maintained at a high potential, information "0" is written (charged floating gate) and if the high potential is changed to a low potential, information "1" is written (no charge on floating gate). Figure 1B shows an equivalent circuit of the cell shown in Figure 1A. Figure 1C shows a cell array MCA comprising such cells $MC_A$, $MC_B$, $MC_C$, . . ., arranged in the form of a matrix, in which $BL_0$, $BL_1$, . . ., represent bit lines and $WL_0$, $WL_1$, . . ., represent word lines.

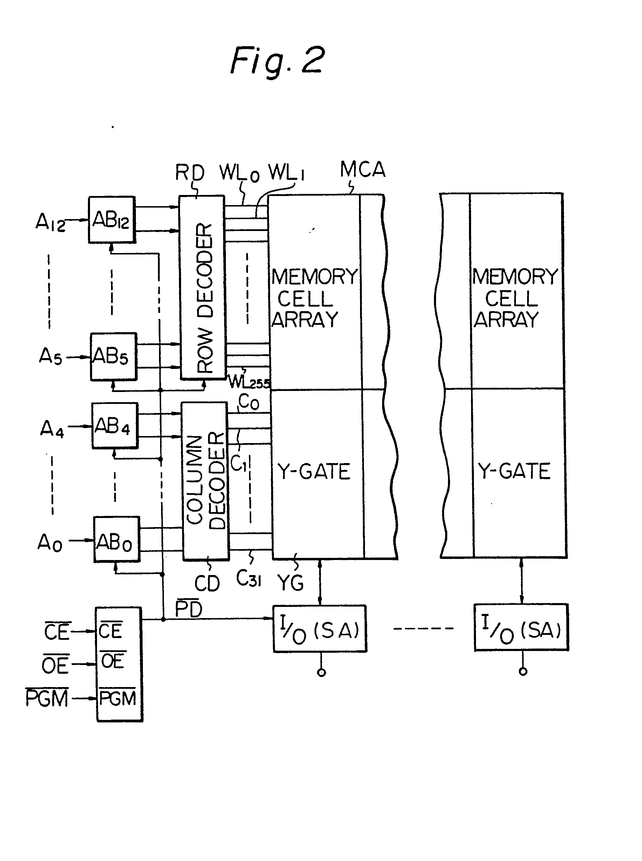

Figure 2 is a block diagram illustrating the entire structure of a conventional EPROM including peripheral circuits, in which $AB_0$ to $AB_{12}$ represent address buffers, RD represents a row decoder, CD represents a column decoder and YG represents a Y gate. In the case where the cell array MCA has 64 K-bits (one block including 8 K-bits), respective cells are selected by 256 word lines $WL_0$ to $WL_{255}$ and 32 column decoder output lines $C_0$ to $C_{31}$. These column decoder output lines $C_0$, $C_1$, . . ., are used for selection of the bit lines $BL_0$, $BL_1$, . . .. In order to select one bit in one block of the cell array MCA, it is necessary to change both the row and column decoder outputs every time. In the normal operation state, this is indispensable so as to prevent multiple selection.

Further, the conventional EPROM is constructed so that, when the whole memory device is non-selected, the whole device is placed in a power-down mode by applying a power-down signal to the circuits, including the address buffer AB, the row decoder RD, and the sense amplifiers SA, in which the electrical power is dissipated.

The undesirable phenomena encountered when electrical stress is applied to the half-selected cells at the time of writing, are as follows:—

2

# 0 055 594

Undesirable phenomenon 1

When the content of the cell $MC_A$ is "0", if information "1" or "0" is written in the cell $MC_B$ while the word line $WL_0$ is maintained at a high potential, the potential of the control gate CG of the cell $MC_A$ simultaneously becomes high ($V_{ss}$ at the drain D), and, therefore, electrons in the floating gate FG of the cell $MC_A$ may be moved (by the tunnel effect) to the control gate CG and the content of the cell $MC_A$ is reversed to "1".

Undesirable phenomenon 2

When the content of the cell $MC_A$ is "0", if information "0" is written in the cell $MC_A$ while maintaining both the word line $WL_1$ and the bit line $BL_0$ at a high level, the drain D of the cell $MC_A$ is also maintained at a high level ($V_{ss}$ at the word line $WL_0$ at this time), and, therefore, electrons in the floating gate FG of the cell $MC_A$ may be moved (by the tunnel effect) to the bit line $BL_0$ and the content of the cell $MC_A$ is reversed to "1".

Undesirable phenomenon 3

When the content of the cell $MC_A$ is "1", if information "1" or "0" is written in the cell $MC_B$ while maintaining the word line $WL_0$ at a high potential, the potential of the control gate CG of the cell $MC_A$ becomes high ($V_{ss}$ at the drain D), and, therefore, electrons may be moved (by the tunnel effect) from the substrate to the floating gate of the cell $MC_A$ and the content of the cell $MC_A$ is reversed to "0".

As illustrated above, in the half-selected cell, the control gate is held at a high potential and the bit wire is held at a low potential, or, the control gate is held at a low potential and the bit wire is held at a high potential, so that the half-selected cell receives an electrical stress. This is the reason that the content of the half-selected cell is changed.

The conventional test method and the time required for the testing in the conventional test method will now be described with reference to an EPROM of 64 K-bits as an example.

Undesirable phenomenon 1

Information "0" is written in all the cells, and then, information "1" is written in all the cells. That is, at (8 K−1) times cells are half-selected and receive electrical stress.

Test duration: 50 ms×8 K-words=409.6 s.

Undesirable phenomenon 2

Initially, all cells store information "0", and then information "0" is written in all the cells. That is, at (8 K−1) times cells are half-selected so that electrical stress is applied to them.

Test duration: 50 ms×8 K-words=409.6 s.

Undesirable phenomenon 3

The information is erased in all the cells (the content is "1" in all the cells), and then, information "1" is written in all the cells. That is, at (8 K−1) times cells are half-selected so that electrical stress is applied to them.

Test duration: 50 ms×8 K-words=409.6 s.

In the above-mentioned test method, for each word unit, that is, for each bit in every 8 K-bits defined by dividing 64 K-bits into 8 blocks, information "0" or "1" should be written during the test mode so that the electrical stress is applied to half-selected cells at (8 K−1) times. Accordingly, if the writing time required for one bit is 50 ms, the time required for writing information "0" or "1" in all the bits of one block is 8 K times the time required for effecting the writing in one bit, that is, several minutes.

We have previously proposed in our patent publication EP—A—0023798, an address buffer circuit for use in a memory device such as an EPROM which enabled high speed testing of the device. In this prior address buffer circuit, a second input circuit was provided, the second input circuit being responsive to an input signal (A) of a level which is higher than normal to cause both outputs (A, A) to be clamped to the same level; in this way, more than one word line could be addressed at a time.

Also, our European Patent Application EP—A—55906, for which the priority date precedes that of the present application but which was published on 14 July 1982, after the date of the present application, relates to an EPROM of the type with which the present invention is concerned: it discloses the use of a test-control circuit which, in response to an address signal of a value higher than normal and a power-down mode signal, generates a control signal (modified power-down signal) which enables all the word lines to be selected at the same time. A similar circuit can be used to enable all bit lines to be selected.

An electrically programmable non-volatile semi-conductor memory device according to the present invention comprises:

a first group of address buffers;

a row decoder which is connected to the first group of address buffers and which has its output connected to a plurality of word lines;

a second group of address buffers;

a column decoder which is connected to the second group of address buffers and which has its output connected to a plurality of column output lines;

a plurality of bit lines which are selected by the output of the column decoder output lines;

an input-output circuit, a bit line selected by a column decoder being connected to the input-output circuit;

a power-down means for placing the first and second groups of address buffers and the input/output circuit in the power-down mode by applying a power-down mode signal;

a memory array of cell transistors which are arranged at the cross-points of the word lines and the bit lines, each memory array transistor having a control gate connected to the word line, a drain connected to the bit line and a floating region for storing electric charges, bit information being written in the cell transistor by placing the selected word line and the selected bit line at predetermined potentials at the same time;

characterized in that the semiconductor memory device further comprises:

a first test-control circuit connected to a given address buffer included in the second group of address buffers which are connected to the column decoder controlling a group of bit lines, the test-control circuit being jointly controlled by the input signal for the address buffer and the power-down mode signal so that when the power-down mode signal is at the power-down mode level and places the input-output circuit in the power-down mode, the test control circuit supplies a control signal to the address buffer, to place the address buffer in the power-down mode;

and a second test control circuit jointly controlled by the input signal for an address buffer in the first group of address buffers connected to the row decoder and the power-down mode signal and which, when the power-down mode signal is at the power-down mode level, supplies a control signal to the address buffer to place that address buffer in the power-down mode;

and for testing, when the power-down mode signal is at a non-power down mode level, the test control circuits respond to address buffer input signals at a test level different from the normal active level and supply to the address buffers control signals which put them into the same state as the power-down mode, the address buffers and decoders being such that in response to the application of the control signals to the said address buffers, the column decoder places all the bit lines of the said group in a selected state at the same time and the row decoder places all the said word lines at the non-selected state at the same time, while the input-output circuit is not in the power-down mode.

Further features and advantages of the present invention will be apparent from the ensuing description of embodiments of the invention with reference to Figures 3 to 7 of the accompanying drawings, Figures 1 and 2 having been described above. In the drawings:—

Figures 1A, 1B and 1C are sectional views of conventional memory cells for an EPROM and a circuit diagram thereof;

Figure 2 is a block diagram showing the whole system of the conventional EPROM;

Figure 3 is a block diagram showing the whole system of one embodiment of the EPROM of the present invention;

Figure 4 illustrates a circuit of an address buffer in Figure 3;

Figure 5 illustrates a partial circuit of a row decoder or column decoder in Figure 3;

Figure 6 illustrates an additional circuit of the present invention shown in Figure 3;

Figure 7 illustrates a circuit of another address buffer in Figure 3.

The conventional test method and the time required for the testing in the present invention will now be described with reference to an EPROM of 64 K-bits as an example.

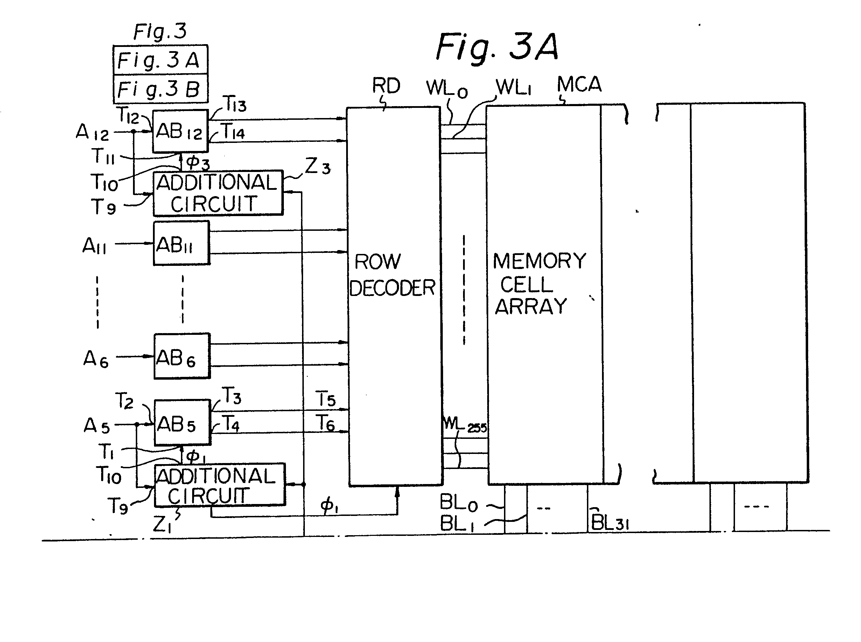

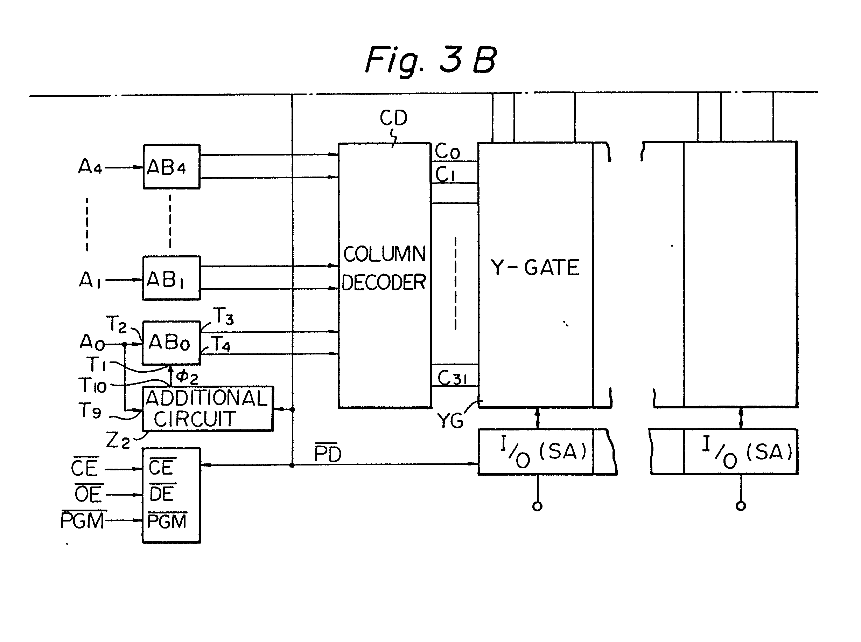

Fig. 3 is a block diagram illustrating one embodiment in which the present invention is applied to an EPROM of 64 K-bits. The same members and elements as shown in Fig. 2 are represented by the same symbols as used in Fig. 2.

In the EPROM of this embodiment, by provisions of additional circuits $Z_1$ through $Z_3$, the following tests become possible.

Undesirable phenomenon 1

Information "0" is written in all the cells, and, then, all the word lines are maintained at a high potential and all the bit lines are maintained at a low potential L ($V_{ss}$). That is, the electrical stress is applied to all cells by placing all cells in a half-selected state where the word lines (control gates) are placed at a high potential and the bit lines (drains) are placed at a low potential.

Test time: 50 ms×32 cycles=1.6 s.

Undesirable phenomenon 2

Information "0" is written in all the cells, and, then, all the word lines are maintained at a low potential L ($V_{ss}$) and all the bit lines are maintained at a high potential. That is, the electrical stress is applied to all cells by placing all cells in a half-selected state where the word lines (control gates) are placed at a low potential and the bit lines (drain) are placed at a high potential.

Test time: 50 ms×256 cycles=12.8 s.

Undesirable phenomenon 3

The information is erased in all the cells (the content is "1" in all the cells), and, then, all the word lines are maintained at a high potential and all the bit lines are maintained at a low potential L ($V_{ss}$). That is, the

4

electrical stress is applied to all cells by placing all cells in half-selected state, the same as in undesirable phenomena 1 above.

Test time: 50 ms×32 cycles=1.6 s.

In the above-mentioned test method, in connection with all the word lines, it is sufficient if they are only selected (maintained at a high potential) or non-selected (maintained at a low potential $V_{ss}$), and in connection with all the bit lines, it is sufficient if only selection of a high potential or a low potential $V_{ss}$ is made. Here, it is noticed that, in connection with the word lines, the term "selection" means to place at a high potential and the term "non-selection" means to place at a low potential, and in connection with the bit lines, the term "selection" means to place at an active state by placing the bit lines at a high or a low potential and the term "non-selection" means to place at a non-active state by placing the bit lines, for example, at a floating state. Accordingly, in connection with, for example, the undesirable phenomenon 1, if only all the word lines are maintained at a high potential selection and all the bit lines are maintained at $V_{ss}$ (non-selection), information "1" can be written in all the cells as in the conventional test method. The time required for this operation is 50 ms. However, in this case, the cell connected to one word line, for example, the cell $MC_A$ shown in Fig. 1C, receives only a stress corresponding to 1/32 of the stress under which writing is effected on the other cells of the same word line (since there are 32 bit lines), and, therefore, this stress is not comparable to the stress given to the cell $MC_A$ in the conventional test method. More specifically, the stress to be applied when writing is effected on the cells $MC_B$, . . ., of the remaining 31 bit lines is not given to the cell $MC_A$. Therefore, in connection with the undesirable phenomena 1 and 3, the required time is multiplied by 32 (cycles). Even if the required time is thus multiplied, the test time is only 1.6 seconds and, therefore, the test time is much shorter than the test time required in the conventional test method. In connection with the undesirable phenomena 1 and 3, since there are 32 bit lines $BL_0$ through $BL_{31}$ to be selected, the required time is multiplied by 32 cycles. However, in the case of the undesirable phenomenon 2, since there are 256 word lines $WL_0$ through $WL_{255}$ to be selected, the required time should be multiplied by 256 cycles. Even if the required time is thus multiplied, the total test time is as short as 12.8 seconds.

In a memory device of this type, in order to avoid multiple selection, it is indispensable that each output of the row decoder RD and the output of the column decoder CD should have only one selection level. The first additional circuit $Z_1$, which is additionally disposed in the present invention, simultaneously maintains all the word lines $WL_0$ through $WL_{255}$ at a selection level (high potential). The second additional circuit $Z_2$ simultaneously maintains the output lines $C_0$ through $C_{31}$ of the column decoder CD at a selection level at the test time (it depends on the input data whether all the bit lines are maintained at a high potential or $V_{ss}$). The third additional circuit $Z_3$ simultaneously maintains all the word lines $WL_0$ through $WL_{255}$ at a non-selection level ($V_{ss}$) at the test time. Accordingly, in connection with the undesirable phenomena 1 and 3, testing is performed by using the additional circuits $Z_1$ and $Z_2$, and in connection with the undesirable phenomenon 2, testing is performed by using the additional circuits $Z_2$ and $Z_3$.

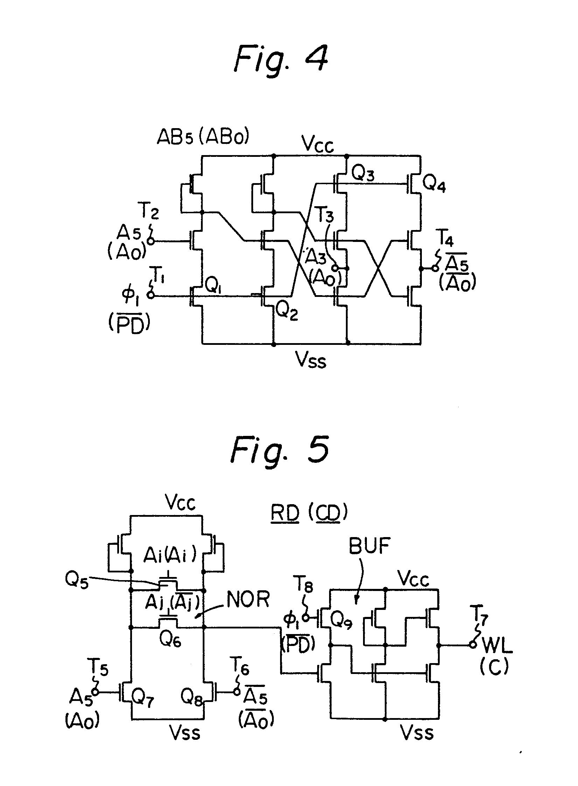

The additional circuit $Z_1$ for selection of all the word lines is added to an address buffer $AB_5$. This address buffer $AB_5$ is of the power-down type, in which, as shown in Fig. 4, by applying a power-down signal $\overline{PD}$ (see Fig. 2) to a terminal $T_1$ for maintaining the address buffer $AB_5$ at a low potential (L) at the time of power-down, transistors $Q_1$ through $Q_4$ are turned off to save power consumption. An address $A_5$ is supplied to a terminal $T_2$ from the outside, and in the case of an active mode, where the signal $\overline{PD}$ is at a high potential (H), the terminal $T_1$ is maintained at a high potential (H) and the transistors $Q_1$ through $Q_4$ are turned on, with the result that the address $A_5$ and reversed address signal $\overline{A_5}$ appear on output terminals $T_3$ and $T_4$. In the case of a power-down mode, the signal $\overline{PD}$ is at a low potential (L) and the terminal $T_1$ is maintained at a low potential (L), and, as described hereinbefore, the transistors $Q_1$ through $Q_4$ are turned off, with the result that the terminals $T_3$ and $T_4$, and, hence, the signals $A_5$ and $\overline{A_5}$, are at a low potential (L).

Fig. 5 illustrates the portion of the row decoder RD, which selects one word line. This portion comprises a nor gate NOR and an output buffer BUF. In all the output buffers, the signals $A_5$ and $\overline{A_5}$ are always applied to terminals $T_5$ and $T_6$, of the NOR gates but the signals which are applied to transistors $Q_5$ and $Q_6$ are different for the NOR gates of different output buffers. In the embodiment shown in Fig. 5, when the potentials of $A_i$, $A_j$ and $A_5$ are low (L), transistors $Q_5$, $Q_6$ and $Q_8$ are turned off and the output of the nor gate NOR becomes high (H). Under other input conditions, the transistor $Q_8$ is turned on or the transistor $Q_7$ and at least one of the transistors $Q_5$ and $Q_6$ are turned on, and the output of the nor gate NOR becomes low (L). The time when the output of the nor gate NOR is at a high level (H) is the time of selection, and at this time, the output terminal $T_7$ of the output buffer BUF is maintained at a high potential (H) and the corresponding word line WL is selected. On the contrary, if the output of the nor gate NOR is at a low potential (L), also the level of the output terminal $T_7$ of the buffer BUF is low (L). Incidentally, the signal $\overline{PD}$ is applied to the terminal $T_8$, and, in the case of the active mode, the inverter load $Q_9$ of the input stage of the buffer BUF is turned on and, in the case of the power-down mode, this inverter load $Q_9$ is turned off.

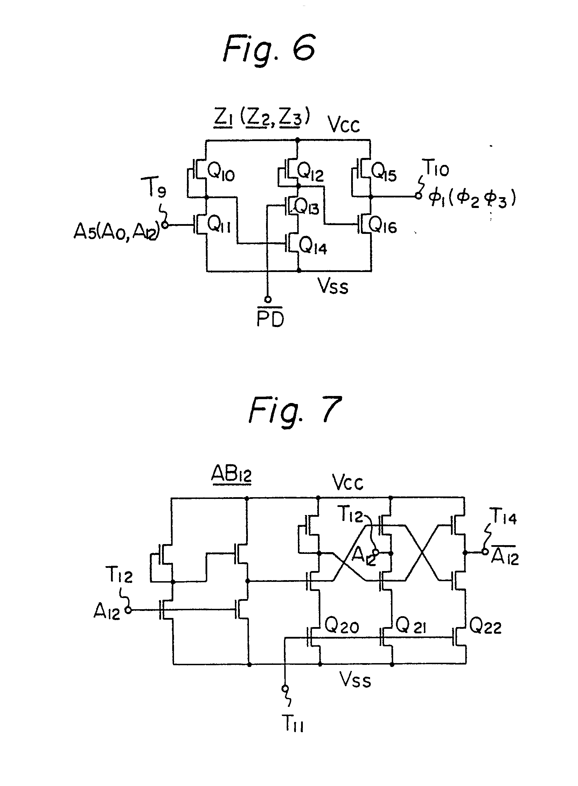

In the present embodiment, the additional circuit $Z_1$ produces a signal $\phi$ which is low (L), even at the time of the test, and this signal is applied to the terminal $T_1$ in Fig. 4 and the terminal $T_8$ in Fig. 5. An example of this circuit is shown in Fig. 6. This circuit $Z_1$ comprises three stages of inverters, and the driver $Q_{11}$ of the first stage ($Q_{10}$ and $Q_{11}$) is kept off at an ordinary TTL level and it is turned on for the first time when a high voltage (for example, 18 V) is applied to the terminal $T_9$. This terminal $T_9$ is a terminal in which the address $A_5$ is received from the outside, but this terminal $T_9$ is inoperative when the address $A_5$ of an

ordinary TTL level is applied to the transistor $Q_{11}$. Drivers of the second stage ($Q_{12}$ through $Q_{14}$) are transistors $Q_{13}$ and $Q_{14}$ operating in an "and" condition and the transistor $Q_{14}$ is controlled by the output of the first stage and the transistor $Q_{13}$ is controlled by the signal $\overline{PD}$. The output stage ($Q_{15}$ and $Q_{16}$) produces the signal $\phi$ which is sent to the terminal $T_{10}$.

In the above-mentioned additional circuit $Z_1$, when a high voltage for selection of all the word lines is applied to the terminal $T_9$ from the outside (at the time of the test), the transistor $Q_{11}$ is turned on, the transistor $Q_{14}$ is turned off and the transistor $Q_{16}$ is turned on, with the result that the potential of the signal $\phi$ becomes low (L). When the potential of the signal $\phi$ becomes low (L), the potential of the terminal $T_1$ in Fig. 4 becomes low (L), and therefore, the transistors $Q_1$ through $Q_4$ are turned off and the potentials of the terminals $T_3$ and $T_4$ become low (L), with the result that the potentials of the terminals $T_5$ and $T_6$ becomes low (L), and hence, the potential of the terminal $T_7$ becomes high (H). Incidentally, the potential of the terminal $T_8$ also simultaneously becomes low (L) to ensure the high potential (H) in the terminal $T_7$. What is important is that when the potential of the signal $\phi$ is low (L), the potentials of the terminals $T_5$ and $T_6$ become low (L). As pointed out hereinbefore, $A_5$ and $\overline{A_5}$ are used for all the word lines. Accordingly, if the potential of the signal $\phi$ becomes low (L), all the word lines $WL_0$ through $WL_{255}$ are maintained at a selection level. In the additional circuit $Z_1$, even if the potential of the signal $\overline{PD}$ is low (L), the potential of the signal $\phi$ is low (L). This is for the purpose of realizing the power-down mode. In an EPROM, ordinarily, the majority of the electric current is consumed by the decoders. Accordingly, if at the time of selection of all the codes the decoder is quite in the same state as that at the time of power-down, as described hereinbefore, the power source current is reduced, and there is an advantage in that this operation can easily be confirmed. In the case of the active mode, since each of the transistors $Q_{13}$ and $Q_{14}$ is turned on, the potential of the signal $\phi$ becomes high (H) and $A_5$ is not equal to $\overline{A_5}$ in the output of the address buffer $AB_5$. Therefore, the terminal $T_7$ in Fig. 5 is maintained at a potential of selection or a potential of non-selection according to the input condition of the nor gate NOR.

Since the second additional circuit $Z_2$ is for selection of all the columns, the same structure as described above is adopted in connection with the address $A_0$ commonly used in the column decoders. Namely if $A_5$ and $\overline{A_5}$ in Fig. 4 are replaced by $A_0$ and $\overline{A_0}$, the structure of the address buffer $AB_0$ is realized, and if $A_5$ and $\overline{A_5}$ in Fig. 5 are replaced by $A_0$ and $\overline{A_0}$, the column decoder is realized and the terminal $T_7$ is one of $C_0$ through $C_{31}$. Furthermore, if the terminal $T_9$ is used as the input terminal of the address $A_0$ in Fig. 6, there is constructed a second additional circuit $Z_2$ in which a signal $\phi2$ is obtained from the terminal $T_{10}$. In this circuit $Z_2$, at the time of the test, a high voltage for selection of all the columns is applied to the terminal $T_9$, and the output $\phi2$ is maintained at a low potential (L). Accordingly, both the signals $A_0$ and $\overline{A_0}$ become low (L) and hence, all the output lines $C_0$ through $C_{31}$ are simultaneously maintained at a high level (H) and all the bit lines $BL_0$ through $BL_{31}$ are simultaneously selected. As described hereinbefore, it depends on the data input whether the selected bit lines are maintained at a high potential or $V_{ss}$.

The third additional circuit $Z_3$ is a circuit for simultaneous non-selection of all the word lines $WL_0$ through $WL_{255}$. The idea of non-selection of all the word lines is contrary to the idea of selection of all the word lines. Accordingly, among the addresses used for the respective word lines of the row decoder RD, one address which provides a low potential (L) for the output terminal $T_7$ (see Fig. 5) when said address is at a high potential (H) is noted. This address is $A_{12}$, and $A_{12}$ or $\overline{A_{12}}$ is inevitably given to any one of the transistors $Q_5$, $Q_6$, ..., of the nor gate shown in Fig. 5. Accordingly, as shown in Fig. 7, power-down transistors $Q_{20}$ through $Q_{22}$ of the address buffer $AB_{12}$ are arranged on the low potential side in contrast to the circuit shown in Fig. 4, so that when the terminal $T_{11}$ is maintained at a low potential (L), the power-down mode is realized. The terminal $T_9$ shown in Fig. 6 is used as the exterior input terminal of the address $A_{12}$, and, at the time of the test, a high voltage for non-selection of all the word lines is applied to this terminal $T_9$. Thus, there is fabricated a third additional circuit $Z_3$ in which an output $\phi3$ of a low potential (L), which simultaneously maintains $A_{12}$ and $\overline{A_{12}}$ at a high level (H) in Fig. 7, is obtained from the terminal $T_{10}$.

In the power-down mode, the power down signal is supplied to the decoders RD, CD and also to the input output portion I/O, whereas, in the present invention, at the test time no power down signal is applied to the input output portion I/O and the operation, which is the same as that in the active time, is carried out.

As will be apparent from the foregoing description, it is sufficient if, for example, a structure shown in Fig. 6 is given to the additional circuits $Z_1$ through $Z_3$ to be added according to the present invention. Therefore, elements to be added are very simple, and the present invention is advantageous in that the test time can be remarkably shortened by the addition of such simple elements.

**Claims**

1. An electrically programmable non-volatile semiconductor memory device comprising:

a first group of address buffers ($AB_5$—$AB_{12}$);

a row decoder (RD) which is connected to the first group of address buffers and which has its output connected to a plurality of word lines (WL);

a second group of address buffers ($AB_0$—$AB_4$);

a column decoder (CD) which is connected to the second group of address buffers and which has its output connected to a plurality of column output lines ($C_0$—$C_{31}$);

6

**0 055 594**

a plurality of bit lines (BL) which are selected by the output of the column decoder output lines;

an input-output circuit (I/O), a bit line selected by a column decoder (CD) being connected to the input-output circuit;

a power-down means for placing the first and second groups of address buffers and the input/output circuit in the power-down mode by applying a power-down mode signal (PD);

a memory array (MCA) of cell transistors which are arranged at the cross-points of the word lines and the bit lines, each memory array transistor having a control gate (CG) connected to the word line, a drain (D) connected to the bit line and a floating region (FG) for storing electric charges, bit information being written in the cell transistor by placing the selected word line and the selected bit line at predetermined potentials at the same time;

characterized in that the semiconductor memory device further comprises:

a first test-control circuit ($Z_2$) connected to a given address buffer ($AB_0$) included in the second group of address buffers ($AB_0$—$AB_4$) which are connected to the column decoder (CD) controlling a group of bit lines (WL), the test-control circuit ($Z_2$) being jointly controlled by the input signal ($A_0$) for the address buffer and the power-down mode signal (PD) so that when the power-down mode signal is at the power-down mode level and places the input-output circuit (I/O) in the power-down mode, the test control circuit ($Z_2$) supplies a control signal ($\phi_2$) to the address buffer ($AB_0$), to place the address buffer ($AB_0$) in the power-down mode;

and a second test control circuit ($Z_3$) jointly controlled by the input signal for an address buffer ($AB_{12}$) in the first group of address buffers connected to the row decoder (RD) and the power-down mode signal and which, when the power-down mode signal is at the power-down mode level, supplies a control signal to the address buffer ($AB_{12}$) to place that address buffer in the power-down mode;

and for testing, when the power-down mode signal (PD) is at a non-power down mode level, the test control circuits ($Z_2$, $Z_3$) respond to address buffer input signals ($A_0$, $A_{12}$) at a test level different from the normal active level and supply to the address buffers ($AB_0$, $AB_{12}$) control signals ($\phi_2$, $\phi_3$) which put them into the same state as the power-down mode, the address buffers and decoders being such that in response to the application of the control signals to the said address buffers, the column decoder places all the bit lines of the said group in a selected state at the same time and the row decoder places all the said word lines at the non-selected state at the same time, while the input-output circuit (I/O) is not in the power-down mode.

2. An electrically programmable non-volatile semiconductor memory device according to claim 1, wherein a third test-control circuit ($Z_1$) is connected to a third address buffer ($AB_5$) included in the first group of address buffers ($AB_5$—$AB_{12}$) which are connected to the row decoder (RD) controlling a group of word lines (WL), the third test-control circuit ($Z_1$) being jointly controlled by the input signal ($A_5$) for the address buffer and the power-down mode signal (PD) so that when the power-down mode signal is at the power-down mode level and places the input-output circuit (I/O) in the power-down mode, the third test control circuit ($Z_1$) supplies a control signal ($\phi_1$) to the address buffer ($AB_5$), to place the address buffer ($AB_5$) in the power-down mode;

and for testing, when the power-down mode signal (PD) is at a non-power down mode level, the third test control circuit ($Z_1$) responds to an address buffer input signal ($A_5$) at a test level different from the normal active level and supplies to the address buffer ($AB_5$) a control signal ($\phi_1$) which puts it into the same state as the power-down mode, the address buffer and decoder being such that in response to the application of the control signal ($\phi_1$) to the said address buffer ($AB_5$), the row decoder places all the said word lines at the selected state at the same time, while the input-output circuit (I/O) is not in the power-down mode.

3. An electrically programmable non-volatile semiconductor memory device according to claim 2, wherein the third test-control circuit ($Z_1$, Figure 6) comprises a first inverter ($Q_{10}$, $Q_{11}$) which is controlled by the input in the same way as the input of the third address buffer ($AB_5$); a second inverter ($Q_{12}$—$Q_{14}$) which is connected to the output of the first inverter and which is controlled by either the output of the first inverter or the power-down mode signal (PD); and a third inverter ($Q_{15}$, $Q_{16}$) which controls the third address buffer (Figure 4) by the output of the second inverter, so that the third address buffer places all the said word lines of the row decoder in the selected state by the output of the third inverter; the first test-control circuit ($Z_2$) comprises a fourth inverter which is controlled by the input in the same way as the input of the first address buffer ($AB_0$); a fifth inverter which is connected to the output of the fourth inverter and which is controlled by either the output of the fourth inverter or the power-down mode signal; and a sixth inverter which controls the first address buffer by the output of the fifth inverter, so that the first address buffer places all the said bit lines of the column decoder in the selected state by the output of the sixth inverter; and the second test-control circuit ($Z_3$) comprises a seventh inverter which is controlled by the input in the same way as the input of the second address buffer ($AB_{12}$); an eighth inverter which is connected to the output of the seventh inverter and which is controlled by either the output of the seventh inverter or the power-down mode signal; and a ninth inverter which controls the second address buffer by the output of the eighth inverter, so that the second address buffer places all the said word lines of the row decoder in the non-selected state by the output of the ninth inverter.

# 0 055 594

**Patentansprüche**

1. Elektrisch programmierbare, nicht-flüchtige Halbleiterspeichervorrichtung mit:
einer ersten Gruppe von Adressenpuffern ($AB_5$—$AB_{12}$);
einem Reihendecoder (RD), der mit der ersten Gruppe von Adresspuffern verbunden ist und dessen Ausgang mit einer Vielzahl von Wortleitungen (WL) verbunden ist;
einer zweiten Gruppe von Adressenpuffern ($AB_0$—$AB_4$);
einem Spaltendecoder (CD), der mit der zweiten Gruppe von Adressenpuffern verbunden ist und dessen Ausgang mit einer Vielzahl von Spaltenausgangsleitungen ($C_0$—$C_{31}$) verbunden ist;
einer Vielzahl von Bitleitungen (BL), die durch den Ausgang der Spaltendecoderausgangsleitungen ausgewählt sind;
einer Eingangs/Ausgangs-Schaltung (I/O), einer Bitleitung, die durch einen Spaltendecoder (CD) ausgewählt ist, der mit der Eingangs/Ausgangs-Schaltung verbunden ist;
einer Abschalteinrichtung, um die ersten und zweiten Gruppen von Adressenpuffern und die Eingangs/Ausgangs-Schaltung in einen Abschaltmodus zu bringen, durch Zuführung eines Abschaltmodussignals (PD);
einer Speicheranordnung (MCA) von Zellentransistoren, die an den Kreuzungspunkten der Wortleitungen und der Bitleitungen angeordnet sind, wobei jeder Speicheranordnungstransistor ein Steuergate (CG) hat, das mit der Wortleitung verbunden ist, ein Drain (D), das mit der Bitleitung verbunden ist, und einen schwimmenden Bereich (FG), um elektrische Ladungen zu speichern, wobei Bitinformation in den Zellentransistor eingeschrieben wird, indem die ausgewählte Wortleitung und die ausgewählte Bitleitung gleichzeitig auf vorbestimmte Potentiale gebracht werden;
dadurch gekennzeichnet, daß die Halbleiterspeichereinrichtung ferner umfaßt:
eine erste Test-Steuerschaltung ($Z_2$), die mit einem vorgegebenen Adressenpuffer ($AB_0$) verbunden ist, der in der zweiten Gruppe von Adressenpuffern ($AB_0$—$AB_4$) enthalten ist, welche mit dem Spaltendecoder (CD) verbunden ist, der eine Gruppe von Bitleitungen (WL) steuert, wobei die Test-Steuer-schaltung ($Z_2$) gemeinsam von dem Eingangssignal ($A_0$) für den Adressenpuffer und von dem Abschalt- modussignal (PD) gesteuert wird, so daß dann, wenn das Abschaltmodussignal auf einem Abschaltmoduspegel ist und die Eingangs/Ausgangsschaltung (I/O) in den Abschaltmodus gebracht wird, die Test-Steuerschaltung ($Z_2$) ein Steuersignal ($\phi_2$) an den Adressenpuffer ($AB_0$) liefert, um den Adressenpuffer ($AB_0$) in den Abschaltmodus zu bringen;
und eine zweite Test-Steuerschaltung ($Z_3$), die gemeinsam durch das Eingangssignal für einen Adressenpuffer ($AB_{12}$) in der ersten Gruppe von Adressenpuffern, welche mit dem Reihendecoder (RD) verbunden ist, und durch das Abschaltmodussignal gesteuert wird und welche dann, wenn das Abschaltmodussignal auf einem Abschaltmoduspegel ist, ein Steuersignal an den Adressenpuffer ($AB_{12}$) liefert, um diesen Adressenpuffer in den Abschaltmodus zu bringen;
und zum Testen, wenn das Abschaltmodussignal (PD) auf einem Nicht-Abschaltmoduspegel ist, die Test-Steuer-schaltungen ($Z_2$, $Z_3$) auf Adressenpuffereingangssignale ($A_0$, $A_{12}$) auf einem Testpegel ansprechen, welcher von dem normalerweise aktiven Pegel verschieden ist, und den Adressenpuffern ($AB_0$, $AB_{12}$) Steuersignale ($\phi_2$, $\phi_3$) zuführen, welche sie in denselben Zustand wie der Abschaltmodus bringen, wobei die Adressenpuffer und Decoder derart sind, daß in Abhängigkeit von der Zuführung von Steuersignalen zu den genannten Adressenpuffern, die Spaltendecoder alle Bitleitungen der genannten Gruppe gleichzeitig in einen ausgewählten Zustand bringen, und der Reihendecoder alle genannten Wortleitungen gleichzeitig in einen nicht-ausgewählten Zustand bringt, während die Eingangs/Ausgangs-schaltung (I/O) in dem Nicht-Abschaltmodus ist.

2. Elektrisch programmierbare, nicht-flüchtige Halbleiterspeichervorrichtung nach Anspruch 1, bei der eine dritte Test-Steuerschaltung ($Z_1$) mit einem dritten Adressenpuffer ($AB_5$) verbunden ist, der in der ersten Gruppe von Adressenpuffern ($AB_5$—$AB_{12}$) enthalten ist, welche mit dem Reihendecoder (RD) verbunden ist, der eine Gruppe von Wortleitungen (WL) steuert, wobei die dritte Test-Steuerschaltung ($Z_1$) gemeinsam von dem Eingangssignal ($A_5$) für den Adressenpuffer und den Abschaltmodussignal (PD) gesteuert wird, so daß dann, wenn das Abschaltmodussignal auf einem Abschaltmoduspegel ist und die Eingangs/Ausgangs-Schaltung (I/O) in den Abschaltmodus bringt, die dritte Test-Steuerschaltung ($Z_1$) ein Steuersignal ($\phi_1$) an den Adressenpuffer ($AB_5$) liefert, um den Adressenpuffer ($AB_5$) in den Abschaltmodus zu bringen;
und zum Testen, wenn das Abschaltmodussignal (PD) auf einem Nicht-Abschaltmoduspegel ist, die dritte Test-Steuerschaltung ($Z_1$) auf ein Adressenpuffereingangssignal ($A_5$) anspricht, das auf einem Testpegel ist, der von dem normalerweise aktiven Pegel verschieden ist, und an den Adressenpuffer ($AB_5$) ein Steuersignal ($\phi_1$) liefert, welche ihn in denselben Zustand wie der Abschaltmodus bringt, wobei der Adressenpuffer und Decoder derart sind, daß ansprechend auf die Zuführung eines Steuersignals ($\phi_1$) zu dem genannten Adressenpuffern ($AB_5$), der Reihendecoder alle genannten Wortleitungen zur selben Zeit auf den ausgewählten Zustand bringt, während die Eingangs/Ausgangs-Schaltung (I/O) nicht in dem Abschaltmodus ist.

3. Elektrisch programmierbare, nicht-flüchtige Halbleiterspeichervorrichtung nach Anspruch 2, bei der die dritte Test-Steuerschaltung ($Z_1$, Figur 6) einen ersten Inverter ($Q_{10}$, $Q_{11}$) umfaßt, der durch die Eingänge in der selben Weise wie der Eingang des dritten Adressenpuffers ($AB_5$) gesteuert wird; einen zweiten

**0 055 594**

Inverter ($Q_{12}$—$Q_{14}$), der mit dem Ausgang des ersten Inverters verbunden ist und entweder durch den Ausgang des ersten Inverters oder durch das Abschaltmodussignal (PD) gesteuert wird; und einen dritten Inverter ($Q_{15}$, $Q_{16}$) der den dritten Adressenpuffer (Figur 4) durch den Ausgang des zweiten Inverters steuert, so daß der dritte Adressenpuffer alle genannten Wortleitungen des Reihendecoders durch den Ausgang des dritten Inverters in den ausgewählten Zustand versetzt; die erste Test-Steuerschaltung ($Z_2$) einen vierten Inverter umfaßt, der durch den Eingang in derselben Weise wie der Eingang des ersten Adressenpuffers ($AB_0$) gesteuert wird; einen fünften Inverter, der mit dem Ausgang des vierten Inverters verbunden ist und der entweder durch den Ausgang des vierten Inverters oder durch das Abschaltmodussignal gesteuert wird; und einen sechsten Inverter, der den ersten Adressenpuffer durch den Ausgang des fünften Inverters steuert, so daß der erste Adressenpuffer alle genannten Bitleitungen des Spaltendecodres durch den Ausgang des sechsten Inverters in den ausgewählten Zustand versetzt; und die zweite Test-Steuerschaltung ($Z_3$) einen siebten Inverter umfaßt, der durch den Eingang in derselben Weise wie der Eingang des zweiten Adressenpuffers ($AB_{12}$) gesteuert wird; einen achten Inverter, der mit dem Ausgang des siebten Inverters verbunden ist und der entweder durch den Ausgang des siebten Inverters oder durch das Abschaltmodussignal gesteuert wird; und einen neunten Inverter, der den zweiten Adressenpuffer durch den Ausgang des achten Inverters steuert, so daß der zweite Adressenpuffer alle genannten Wortleitungen des Reihendecoders durch den Ausgang des neunten Inverters in den nicht ausgewählten Zustand versetzt.

**Revendications**

1. Mémoire à semi-conducteur rémanente, programmable électriquement, comportant:
un premier groupe de tampons d'adresse ($AB_5$—$AB_{12}$);
un décodeur de rangée (RD) qui est connecté au premier groupe de tampons d'adresse et dont une sortie est connectée à plusieurs lignes de mot (WL);
un second groupe de tampons d'adresse ($AB_0$—$AB_4$);
un décodeur de colonne (CD) qui est connecté au second groupe de tampons d'adresse et dont une sortie est connectée à plusieurs lignes de sortie de colonne ($C_0$—$C_{31}$);
plusieurs lignes de bit (BL) qui sont sélectionnées par la sortie des lignes de sortie de décodeur de colonne;
un circuit d'entrée-sortie (I/O), une ligne de bit sélectionnée par un décodeur de colonne (CD) étant connectée au circuit d'entrée-sortie;
un dispositif de coupure d'alimentation destiné à placer le premier et le second groupe de tampons d'adresse et le circuit d'entrée-sortie dans le mode de coupure d'alimentation par l'application d'un signal de mode de coupure d'alimentation (PD);
une matrice de mémoire (MCA) de transistors de cellules qui sont disposés aux points de croisement des lignes de mot et des lignes de bit, chaque transistor de matrice de mémoire comprenant une grille de commande (CG) connectée à la ligne de mot, un drain (D) connecté à la ligne de bit et une région flottante (FG) pour emmagasiner des charges électriques, des informations binaires étant écrites dans le transistor de cellules en plaçant la ligne de mot sélectionnée et la ligne de bit sélectionnée et la ligne de bit sélectionnée à des potentiels prédéterminés, en même temps;
caractérisé en ce que la mémoire à semi-conducteur comporte en outre:
un premier circuit de commande d'essai ($Z_2$) connecté à un tampon d'adresse donné ($AB_0$) inclus dans le second groupe de tampons d'adresse ($AB_0$—$AB_4$) qui sont connectés au décodeur de colonne (CD) commandant un groupe de lignes de bit (WL), le circuit de commande d'essai ($Z_2$) étant commandé conjointement par le signal d'entrée ($A_0$) pour le tampon d'adresse et le signal de mode de coupure d'alimentation (PD) de manière que lorsque le signal de mode de coupure d'alimentation se trouve au niveau de mode de coupure d'alimentation et place le circuit d'entrée-sortie (I/O) dans le mode de coupure d'alimentation, le circuit de commande d'essai ($Z_2$) fournisse un signal de commande ($\phi_2$) au tampon d'adresse ($AB_0$) pour placer le tampon d'adresse ($AB_0$) dans le mode de coupure d'alimentation;
et un second circuit de commande d'essai ($Z_3$) commandé conjointement par le signal d'entrée pour un tampon d'adresse ($AB_{12}$) dans le premier groupe des tampons d'adresse connectés au décodeur de rangée (RD) et le signal de mode de coupure d'alimentation et qui, quand le signal de mode de coupure d'alimentation est au niveau du mode de coupure d'alimentation, fournit un signal de commande au tampon d'adresse ($AB_{12}$) pour placer ce tampon d'adresse dans le mode de coupure d'alimentation;
et, pour l'essai, quand le signal de mode de coupure d'alimentation (PD) est à un niveau de mode de non coupure d'alimentation, les circuits de commande d'essai ($Z_2$, $Z_3$) réagissent à des signaux d'entrée de tampon d'adresse ($A_0$, $A_{12}$) à un niveau d'essai différent du niveau actif normal et fournissent aux tampons d'adresse ($AB_0$, $AB_{12}$) des signaux de commande ($\phi_2$, $\phi_3$) qui les placent dans le même état que dans le mode de coupure d'alimentation, les tampons d'adresse et les décodeurs étant tels que, en réponse à l'application des signaux de commande auxdits tampons d'adresse, le décodeur de colonne place toutes les lignes de bit dudit groupe dans un état sélectionné en même temps et le décodeur de rangée place toutes les lignes de mot à l'état non sélectionné en même temps pendant que le circuit d'entrée-sortie (I/OI) n'est pas dans le mode de coupure d'alimentation.

2. Mémoire à semi-conducteur rémanente, programmable électriquement, selon la revendication 1,

9

dans laquelle un troisième circuit de commande d'essai ($Z_1$) est connecté à un troisième tampons d'adresse ($AB_5$) inclus dans le premier groupe des tampons d'adresse ($AB_5$—$AB_{12}$) qui sont connectés au décodeur de rangée (RD) commandant un groupe de lignes de mot (WL), le troisième circuit de commande d'essai ($Z_1$) étant commandé conjointement par le signal d'entrée ($A_5$) pour le tampon d'adresse et le signal de mode de coupure d'alimentation (PD) de manière que, lorsque le signal de mode de coupure d'alimentation se trouve au niveau de mode de coupure d'alimentation et place le circuit d'entrée-sortie (I/O) dans le mode de coupure d'alimentation, le troisième circuit de commande d'essai ($Z_1$) fournisse un signal de commande ($\phi_1$) au tampon d'adresse ($AB_5$) pour placer ce tampon d'adresse ($AB_5$) dans le mode de coupure d'alimentation;·

et, pour l'essai, quand le signal de mode de coupure d'alimentation (PD) est à un niveau de mode de non coupure d'alimentation, le troisième circuit de commande d'essai ($Z_1$) réagit à un signal d'entrée de tampon d'adresse ($A_5$) à un niveau différent du niveau actif normal et fournit au tampon d'adresse ($AB_5$) un signal de commande ($\phi_1$) qui le place dans le même état que dans le mode de coupure d'alimentation, le tampon d'adresse et le décodeur étant tels que, en réponse à l'application du signal de commande ($\phi_1$) audit tampon d'adresse ($AB_5$), le décodeur de rangée place toutes les lignes de mot à l'état sélectionné en même temps tandis que le circuit d'entrée-sortie (I/O) n'est pas dans le mode de coupure d'alimentation.

3. Mémoire à semi-conducteur rémanente, programmable électriquement, selon la revendication 2, dans laquelle un troisième circuit de commande d'essai ($Z_1$, Figure 6) comporte un premier inverseur ($Q_{10}$, $Q_{11}$) qui est commandé par l'entrée de la même manière que l'entrée du troisième tampon d'adresse ($AB_5$); un second inverseur ($Q_{12}$—$Q_{14}$) qui est connecté à la sortie du premier inverseur et qui est commandé soit par la sortie du premier inverseur, soit par le signal de mode de coupure d'alimentation (PD); et un troisième inverseur ($Q_{15}$, $Q_{16}$) qui commande le troisième tampon d'adresse (Figure 4) par la sortie du second inverseur de manière que le troisième tampon d'adresse place toutes lesdites lignes de mot du décodeur de rangée dans l'état sélectionné par la sortie du troisième inverseur; le premier circuit de commande d'essai ($Z_2$) comprenant un quatrième inverseur qui est commandé par l'entrée de la même manière que l'entrée du premier tampon d'adresse ($AB_0$); un cinquième inverseur qui est connecté à la sortie du quatrième inverseur et qui est commandé par la sortie du quatrième inverseur ou par le signal de mode de coupure d'alimentation; et un sixième inverseur qui commande le premier tampon d'adresse par la sortie du cinquième inverseur de manière que le premier tampon d'adresse place toutes lesdites lignes de bit du décodeur de colonne dans l'état sélectionné par la sortie du sixième inverseur; et le second circuit de commande d'essai ($Z_3$) comportant un septième inverseur qui est commandé par l'entrée de la même manière que l'entrée du second tampon d'adresse ($AB_{12}$); un huitième inverseur qui est connecté à la sortie du septième inverseur et qui est commandé par la sortie du septième inverseur ou par le signal de mode de coupure d'alimentation; et un neuvième inverseur qui commande le second tampon d'adresse par la sortie du huitième inverseur de manière que le second tampon d'adresse place toutes lesdites lignes de mot du décodeur de rangée dans l'état non sélectionné par la sortie du neuvième inverseur.

## Fig. 1A

## Fig. 1B

## Fig. 1C

# Fig. 2

# Fig. 3A

| Fig. 3 | |
|---|---|
| Fig. 3 A | |
| Fig. 3 B | |

**MEMORY CELL ARRAY** — MCA

**ROW DECODER** — RD

WL₀, WL₁ ... WL₁ ... M255

BL₀, BL₁ ... BL₃₁

ADDITIONAL CIRCUIT — Z₃

ADDITIONAL CIRCUIT — Z₁

AB₁₂, AB₁₁ ... AB₆, AB₅

T₁₃, T₁₄, Φ₃, T₁₂, A₁₂, T₁₁, T₁₀, T₉

T₅, T₆, T₃, T₄, T₂, T₁, A₅, A₆, A₁₁, Φ₁

Fig. 3 B

# Fig. 4

AB5 (ABo)

Vcc

Q3   Q4

T2

A5
(Ao)

T3

A3
(Ao)

T4

A5
(Ao)

φ1
(PD)

T1

Q1

Q2

Vss

# Fig. 5

Vcc

RD (CD)

Ai(Ai)

Q5

Aj(Aj)

NOR

Q6

BUF

T8

Vcc

φ1
(PD)

Q9

T7

WL
(C)

T5

A5
(Ao)

Q7

Q8

T6

A5
(Ao)

Vss

Vss

5

# Fig. 6

$\underline{Z_1}$ ($\underline{Z_2}$, $\underline{Z_3}$) Vcc

# Fig. 7

$\underline{AB_{12}}$ Vcc